# EUROPEAN PATENT SPECIFICATION

(11) **EP 2 910 664 B1**
(45) Date of publication and mention of the grant of the patent: **03.04.2019**
(21) Application number: 14156256.1
(22) Date of filing: 21.02.2014
(51) Int. Cl.: C23C 14/28, C23C 14/50

(54) **DEVICE FOR DEPOSITING A MATERIAL BY PULSED LASER DEPOSITION AND A METHOD FOR DEPOSITING A MATERIAL WITH THE DEVICE**
VORRICHTUNG ZUR ABSCHEIDUNG EINES MATERIALS DURCH GEPULSTE LASERABSCHEIDUNG SOWIE GEPULSTES LASERVERFAHREN ZUR ABSCHEIDUNG EINES MATERIALS MIT DER VORRICHTUNG
DISPOSITIF POUR DÉPOSER UN MATÉRIAU PAR DÉPÔT PAR LASER PULSÉ ET PROCÉDÉ DE DÉPÔT D'UN MATÉRIAU AVEC LE DISPOSITIF

(43) Date of publication of application: 26.08.2015
(73) Proprietor: Solmates B.V., 7521 PE Enschede (NL)
(72) Inventor: Dekkers, Jan Matthijn, 7611 CB Aadorp (NL); Janssens, Jan Arnaud, 7412 DL Deventer (NL)
(74) Representative: 't Jong, Bastiaan Jacob

(56) References cited:
- EP-A1- 2 159 300
- US-A- 5 084 300
- US-A- 6 063 455
- DATABASE WPI Week 199836 Thomson Scientific, London, GB; AN 1998-425001 XP002727895, & KR 970 042 261 A (INST ADVANCED ENG) 24 July 1997 (1997-07-24)

## Description

The invention relates to a device for depositing a material by pulsed laser deposition according to the preamble of claim 1 and a method for depositing a material with the device according to the preamble of claim 9.

Such a device and method is for example known from US 6063455.

Using pulsed laser deposition, a target material is irradiated by a laser in a vacuum chamber. Due to the excitation, a plasma plume of material is created, with its central axis perpendicular to the position of incidence on the target. This plasma plume of material is directed at a substrate, on which deposition of the particles in the plasma plume occurs.

It would be beneficial to be able to apply pulsed laser deposition on relatively large surface areas in a broad field op applications. However, currently available pulsed laser deposition methods on large surface areas have however not allowed the production of layered structures on other than circular surface areas, for instance for the production of large organic light emitting displays (OLEDs). One such a method restricted to circular substrates as currently available is described in EP 2159300.

It is therefore an object of the invention to provide a device, in which the above-mentioned disadvantages are reduced or even obviated.

This object is achieved with a device according to claim 1.

In its use, the substrate is translated by the movement of the substrate holder in the first direction while, at the same time, the movement of the plasma plume in the second direction perpendicular to the first direction of the plasma plume over the surface creates a layer of target material on the substrate.

Since the plasma plume consists of a distribution of particles, and since the speed of the movement of the plasma plume over the substrate in the second direction is generally larger than the speed of the movement of the substrate in its holder, the movement of the substrate and the position of incidence will generally result in a homogeneous layer of target material on the substrate.

The control of the position of incidence of the laser on the target may be varied both by moving the laser in the second direction and/or tilting the laser.

The composition of the target may be homogeneous in order to deposit a layer of one target material, but may as well be inhomogeneous if deposition of different materials in one step on top of each other is desired. To this end, the device may also comprise more than one target, of which the composition may vary per target and/or within the target.

Multiple lasers may be used or and/or one laser may be split in various beams. In this way, multiple points of incidence are created on the surface of the target. The length of the target in the second direction may for instance be distributed in segments and each of the laser beams will cover at least one segment in the creation of a plasma plume. In that way the amount of target material excited simultaneously may increase and the deposition may take place at a higher rate.

Also, one or more individual points of incidence may be created on the surface of the target which does not substantially move in the second direction over the target surface, such to create a line of target material on the substrate in the first direction.

The first direction may be chosen from the length or width direction of the substrate and the second direction will accordingly be the other direction of the length or width.

In an embodiment of the device according to the invention, the movement of the position of incidence of the laser is linearly linked to the movement of the substrate holder.

By linking the movement of the position of incidence on the target to the movement of the substrate by its holder, the homogeneity of the layer deposited by the device on the substrate is further increased. The link between the movement of the position of incidence and the movement of the substrate ensures that the path of the plasma plume over the surface of the substrate will be linear. A non-linear relationship could cause differences in layer thickness over the surface of the substrate which could, in some applications, be a disadvantage. In other applications, differences in layer thickness could however be an advantage.

In the device according to the invention, the controller resets the position of incidence of the laser, when viewed in the direction of movement, to the closest edge of the substrate upon arriving at the distal edge of the substrate.

The closest edge of the substrate is the edge, where the generated plasma plume starts with depositing particles on the substrate, while the distal edge of the substrate is the edge, where the path of the plasma plume ends. By moving the position of incidence such that the resulting plasma plume moves from the closest edge to the distal edge and back in a repetitive movement, a large area of the substrate may be deposited with target material in a continuous process.

In the case that multiple laser beams are used, each of the laser beams may only have to reset along the segment of that laser beam.

The device according to the invention further comprises blocking means for blocking deposition of the plasma plume on the substrate during resetting of the position of incidence of the laser on the target.

When the position of incidence reaches the position at which the plume reaches the distal edge of the substrate, the position needs to be reset such that the plume continues at the closest edge. However, the resetting movement causes a difference in the distance between each passage of the plasma plume, thereby possibly negatively influencing the homogeneity of the layer, the homogeneity of defects or the homogeneity of the electrical properties of the resulting layer. By blocking the laser during this resetting movement, the chance of inhomogeneous layers, inhomogeneous damage and inhomogeneous electrical properties is decreased.

These blocking means may for instance comprise a shield, arranged between the target and the substrate or between the laser source and the target or the device may comprise a second substrate, which is deposited with target material during the resetting procedure. The blocking means may also comprise optical means, such as mirrors or prisms or may also comprise other means to block the laser during the resetting movement. The blocking means may also comprise means to turn off the laser during the resetting movement.

In another embodiment of the device according to the invention, the position of incidence of the laser on the target is also movable in the first direction along the surface of the target.

By varying the position accordingly, the laser may hit different areas of the target. Due to a possible difference in composition of the target, this allows different areas of the target to be deposited on the substrate.

In a preferred embodiment of the device according to the invention, the target is at least partially curved, preferably cylindrical, over the full length in the second direction of the substrate.

When the laser hits the target, a plasma plume is created perpendicular to the tangent of the position of incidence. As such, when moving the position of incidence along the first direction over the target surface, the angle of the resulting plasma plume with respect to the substrate will vary. As a consequence, the distance to be travelled by the particles before reaching the substrate changes. Since the particles in the plasma plume will slow down during the trajectory between the target and the substrate, variation of the position of incidence along the curvature of the target allows tuning of the kinetics, e.g. particle velocity, of the particles when they reach the substrate.

Since the position of incidence will also vary in the second direction along the surface of the target in order to deposit the target material on a large surface area of the substrate, it is preferred that the target has a constant cross-section in the direction parallel to the second direction of the substrate.

In a further preferred embodiment of the device according to the invention, the target is a cylindrical rod.

A cylindrical rod has a constant cross-section and can be manufactured relatively easy.

Preferably, the target is rotatable around its axis parallel to the second direction of the substrate.

The rotation of the cylindrical rod around the axis allows constant and even ablation of material from the target along its curvature, such that the target will keep its cylindrical shape, despite substantial ablation. Non-constant ablation could lead to unpredictable changes in the curvature of the surface of the target over time, thereby changing the plasma plume angle, whereas rotation of the target prevents such changes, or at least makes these changes more predictable.

In another embodiment of the device according to the invention, the length in the second direction of the substrate is at least 20 centimeters.

The device according to the invention allows the coating of relatively large surface areas, especially for substrates having a length in the second direction of at least 20 centimeters. More preferentially, the length is at least 30 centimeters. Most preferentially, the length is at least 50 centimeters.

In yet another embodiment of the device according to the invention, the substrate comprises a glass layer provided with a layer of electroluminescent material.

At least the deposition of the top layer of the layered structure can be built by a device according to the invention. If a relatively large substrate area is chosen, for instance with a second direction of at least 50 centimeters, the device allows the manufacture of large surface area displays.

The object of the invention is further achieved with a method according to claim 9

By moving the plasma plume over the substrate from the closest edge to the distal edge and back in a repetitive movement in the second direction in a constant speed that is generally larger than the constant speed of the movement of the substrate, the method will generally result in a homogeneous layer of target material on the substrate.

When the plasma plume would be moved accordingly without inhibiting deposition of particles from the plasma plume, these movements will create an endless V-movement over the substrate surface. Because of this movement, the time between the passage of a plasma plume, e.g. its central axis, will vary in the second direction of the substrate. In the first place, this may lead to inhomogeneity of the layer on the substrate. More importantly, it is especially found that such variation causes a difference in the amount of damage or difference in the electrical properties obtained on the substrate. In order to prevent this, the deposition of the particles from the plasma plume on the substrate is inhibited during the back movement of the position of incidence.

By varying the pattern of deposition of the plasma plume over the surface, it is also possible to vary the thickness of the layered structure if required. This may also be achieved by at least temporarily making the movement of the substrate in the first direction non-linear to the movement of the point of incidence in the second direction.

In general, the use of the device according to the invention may for instance be an advantage in the production of various structures, and especially large surface organic light emitting displays (OLEDs) or TFTs. OLEDs also encompasses transparent OLEDs or top-emitting OLEDs.

An OLED comprises a substrate, preferably made of glass, on which two conducting layers are deposited with an emissive electroluminescent layer between those layers. OLEDs are built in layers and the deposition of the second conducting layer on top of the emissive electroluminescent layer may damage the latter, thereby increasing the chance of malfunction of the resulting device, e.g. due to leakage current or short circuiting. Application of currently available pulsed laser deposition methods as such increases the chance of such damages, whereas the current device allows tuning of the particle velocity by variation of the position of incidence. The application of the current device especially in building OLEDs decreases the chance of inhomogeneous damage to the electroluminescent layer. At least the deposition of the top layer of the layered structure can be built by a device according to the invention. If a relatively large substrate area is chosen, for instance with a second direction of at least 50 centimeters, the device allows the manufacture of large surface area displays.

In the production of active thin film transistors (TFTs), the device can be used to apply a high-mobility material such as IGZO (indium gallium zinc oxide), ZTO (zinc tin oxide) or ZnON (zinc oxynitride). The application of the current device in building TFTs especially decreases the chance of inhomogeneous electrical properties of the resulting product.

The controller may comprise means for controlling one or more substrate holders, one or more target holders, laser(s) and which may be programmed to execute an automated deposition program.

These and other features of the invention will be elucidates in conjunction with the accompanying drawings.
Figure 1 shows a schematic view of an embodiment of the device according to the invention.
Figure 2A and 2B show a top view of an embodiment of the device according to the invention with a variation of the position of incidence along the curvature of the target.
Figure 3 shows a deposition pattern on a substrate according to the invention.

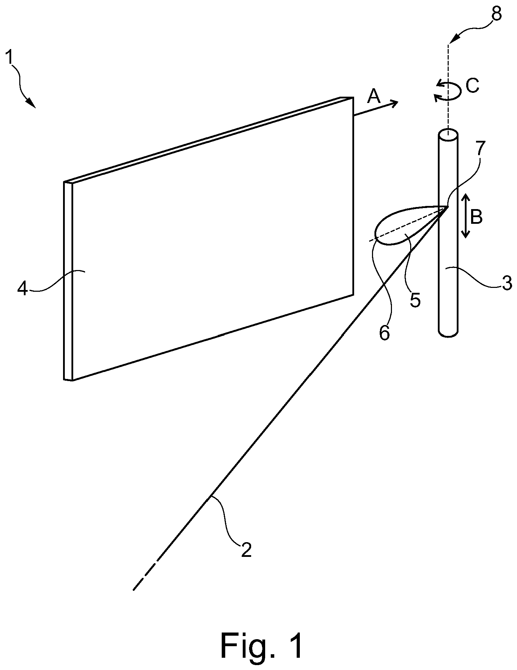

In figure 1, a device 1 is shown comprising a laser 2, a target 3 in the shape of a cylindrical rod and a substrate 4. By hitting the target 3 with the laser 2, a plasma plume 5 of particles with a center 6 is created directed at the substrate 4. The substrate 4 is at least movable in the first direction A, whereas the position of incidence 7 of the laser on the target 3 may be changed in the second direction B. The substrate 4 may additionally be rotated around its axis 8 in direction C. By the movement of the substrate 4 in direction A and the simultaneous movement of the position of incidence 7 of the laser 2 over the surface of the target 3 in direction B, the plasma plume 5 is moved in a repeating pattern over the substrate 4.

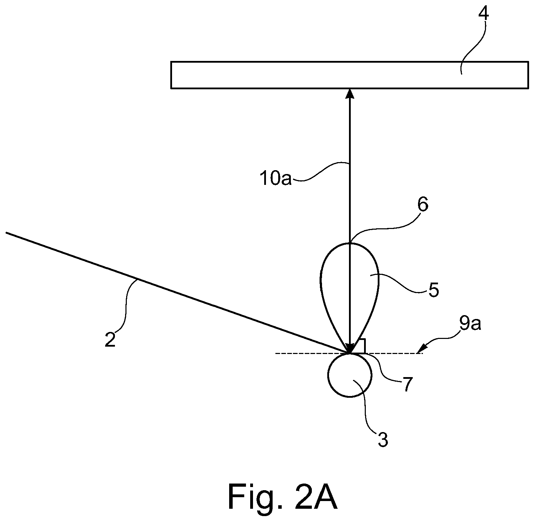

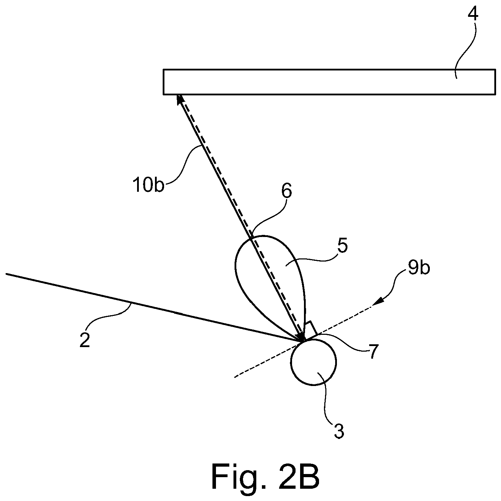

The movement of the position of incidence 7 of the laser 2 on the target 3 is shown in figures 2A and 2B. In figure 2A, the position of incidence 7 of the laser 2 is chosen such that the resulting plasma plume 5, perpendicular to the tangent 9a of the surface of the target 3 will have a relatively short distance 10a to the substrate 4 compared to figure 2B. In this figure, the position of incidence 7 is chosen more towards the side of the target 3 and as a consequence, the resulting plasma plume 5, also being perpendicular to the tangent 9b of the surface of the target 3, will have a longer distance 10b to the substrate 4. Because of this longer distance 10b, the speed of the particles of the plasma plume 5 hitting the surface of the substrate 4 will have a lower speed, decreasing the chance of damage to the substrate 4.

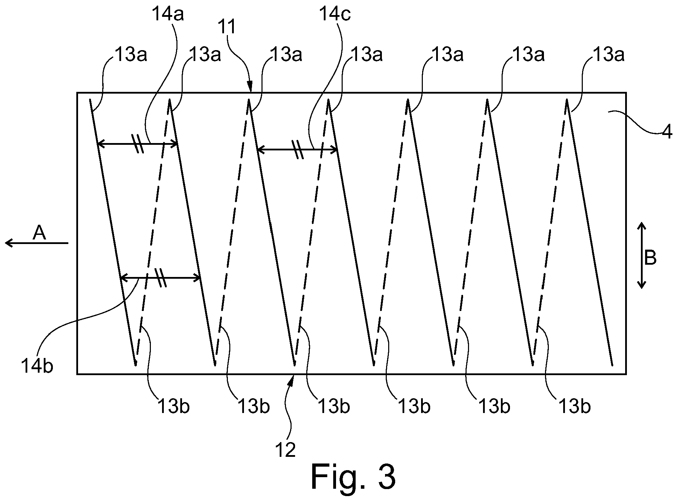

Figure 3 shows a pattern of the movement of the center 6 of the plasma plume 5 on a part of the surface of the substrate 4 in an enlarged view for clarity reasons. In this movement, the plasma plume 5 is moved repetitively between a first edge 11 towards a second edge 12 in a trajectory 13 while moving the substrate 4 in a first direction A. On the part 13a of the trajectory from the first edge towards the second edge 12, deposition from the plasma plume 5 takes place on the substrate 4, whereas on the return path 13b, shown in dashed lines, deposition on the substrate 4 will be inhibited. Since the movement of the substrate 4 is constant, the time and distance between subsequent passages 14a,b,c of the plasma plume 5 will be both the same in the second direction B and the first direction A of the substrate 4, thereby reducing the chances of inhomogeneous deposition but, more importantly, inhomogeneous damage to or inhomogeneous electrical properties in the substrate 4.

## Claims

1. Device (1) for depositing a material by pulsed laser deposition, the device (1) comprising:
- a vacuum chamber;
- at least one substrate holder with a substrate (4), arranged inside the vacuum chamber, the substrate (4) having a first, second and third direction, each of the three directions perpendicular to each other, wherein the substrate (4) is movable by the substrate holder in the first direction (A) ;
- a target holder with a target (3), arranged inside the vacuum chamber and wherein the target (3) extends over substantially the full length in the second direction (B) of the substrate (4) and parallel to the substrate (4);
- at least one laser (2) for irradiating the target (3), thereby creating a plasma (5) of material that deposits on the substrate (4), wherein the position of incidence (7) of the laser (2) on the target (3) is moveable parallel to the second direction (B) of the substrate (4); and
- a controller for controlling the movement of the substrate holder and the movement of the position of incidence (7) of the laser (2) on the target (3)
wherein the controller resets the position of incidence (7) of the laser (2), when viewed in the direction of movement (B), to the closest edge of the substrate (4) upon arriving at the distal edge of the substrate (4),
**characterized by**
- blocking means for blocking deposition of the plasma plume (5) on the substrate (4) during resetting of the position of incidence (7) of the laser (2) on the target (3).

2. Device (1) according to claim 1, wherein the movement of the position of incidence (7) of the laser (2) is linearly linked to the movement of the substrate holder (4).

3. Device (1) according to any of the claims, wherein the position of incidence (7) of the laser on the target (3) is also movable in the first direction (A) along the surface of the target (3).

4. Device (1) according to claim 3, wherein the target (3) is at least partially curved, preferably cylindrical, over the full length in the second direction (B) of the substrate (4).

5. Device (1) according to claim 4, wherein the target (3) is a cylindrical rod.

6. Device (1) according to claim 5, wherein the target (3) is rotatable around its axis parallel to the second direction (B) of the substrate (4).

7. Device (1) according to any of the preceding claims, wherein the length in the second direction (B) of the substrate (4) is at least 20 centimeters.

8. Device (1) according to any of the preceding claims, wherein the substrate (4) comprises a glass layer provided with a layer of electroluminescent material.

9. Method for depositing a material by pulsed laser deposition with a device (1) according to any of the preceding claims, the method comprising the repetitive steps of:
- moving the substrate (4) in the first direction (A) at a constant speed;
- moving the position of incidence (7) of the laser (2) on the target (3) in the second direction (A) at a constant speed, when viewed in the second direction (B), from the closest edge of the substrate (4) towards the distal edge of the substrate (4);
**characterized by**
- moving the position of incidence (7) of the laser (2) back, when viewed in the second direction (B), from the distal edge of the substrate (4) to the closest edge of the substrate (4), inhibiting deposition of particles on the substrate (4).

## Patentansprüche

1. Vorrichtung (1) zum Abscheiden eines Materials durch gepulste Laserabscheidung, wobei die Vorrichtung (1) umfasst:
- eine Vakuumkammer;
- mindestens einen Substrathalter mit einem Substrat (4), der innerhalb der Vakuumkammer angeordnet ist, wobei das Substrat (4) eine erste, zweite und dritte Richtung aufweist, jede der drei Richtungen senkrecht zueinander, wobei das Substrat (4) durch den Substrathalter in der ersten Richtung (A) bewegbar ist;
- einen Targethalter mit einem Target (3), der innerhalb der Vakuumkammer angeordnet ist, und wobei sich das Target (3) über im Wesentlichen die gesamte Länge in der zweiten Richtung (B) des Substrats (4) und parallel zum Substrat (4) erstreckt;
- mindestens einen Laser (2) zum Bestrahlen des Targets (3), dadurch Erzeugen eines Plasmas (5) von Material, das sich auf dem Substrat (4) abscheidet, wobei die Einfallsposition (7) des Lasers (2) auf dem Target (3) parallel zur zweiten Richtung (B) des Substrats (4) bewegbar ist; und
- eine Steuerung zum Steuern der Bewegung des Substrathalters und der Bewegung der Einfallsposition (7) des Lasers (2) auf dem Target (3),
wobei die Steuerung die Einfallsposition (7) des Lasers (2), in der Bewegungsrichtung (B) gesehen, bei Ankunft am distalen Rand des Substrats (4) auf den nächstgelegenen Rand des Substrats (4) zurücksetzt, **gekennzeichnet durch**
- Blockiermittel zum Blockieren von Abscheidung der Plasmaflamme (5) auf dem Substrat (4) während Zurücksetzens der Einfallsposition (7) des Lasers (2) auf dem Target (3).

2. Vorrichtung (1) nach Anspruch 1, wobei die Bewegung der Einfallsposition (7) des Lasers (2) linear mit der Bewegung des Substrathalters (4) verknüpft ist.

3. Vorrichtung (1) nach einem der Ansprüche, wobei die Einfallsposition (7) des Lasers auf dem Target (3) ebenfalls in der ersten Richtung (A) entlang der Oberfläche des Targets (3) bewegbar ist.

4. Vorrichtung (1) nach Anspruch 3, wobei das Target (3) über die gesamte Länge in der zweiten Richtung (B) des Substrats (4) mindestens teilweise gekrümmt, vorzugsweise zylindrisch ist.

5. Vorrichtung (1) nach Anspruch 4, wobei das Target (3) ein zylindrischer Stab ist.

6. Vorrichtung (1) nach Anspruch 5, wobei das Target (3) um seine Achse parallel zur zweiten Richtung (B) des Substrats (4) drehbar ist.

7. Vorrichtung (1) nach einem der vorstehenden Ansprüche, wobei die Länge in der zweiten Richtung (B) des Substrats (4) mindestens 20 Zentimeter beträgt.

8. Vorrichtung (1) nach einem der vorstehenden Ansprüche, wobei das Substrat (4) eine Glasschicht umfasst, die mit einer Schicht elektrolumineszenten Materials versehen ist.

9. Verfahren zum Abscheiden eines Materials durch gepulste Laserabscheidung mit einer Vorrichtung (1) nach einem der vorstehenden Ansprüche, wobei das Verfahren die sich wiederholenden Schritte umfasst des:
- Bewegens des Substrats (4) in der ersten Richtung (A) mit einer konstanten Geschwindigkeit;
- Bewegens der Einfallsposition (7) des Lasers (2) auf dem Target (3) in der zweiten Richtung (A) mit einer konstanten Geschwindigkeit, in der zweiten Richtung (B) gesehen vom nächstgelegenen Rand des Substrats (4) zum distalen Rand des Substrats (4) hin;
**gekennzeichnet durch**
- Bewegen der Einfallsposition (7) des Lasers (2), in der zweiten Richtung (B) gesehen, vom distalen Rand des Substrats (4) zum nächstgelegenen Rand des Substrats (4) zurück, Hemmen von Partikelabscheidung auf dem Substrat (4).

## Revendications

1. Dispositif (1) pour déposer une matière par dépôt par laser pulsé, le dispositif (1) comprenant:
- une chambre à vide ;
- au moins un support de substrat avec un substrat (4), agencé à l'intérieur de la chambre à vide, le substrat (4) ayant une première, une deuxième et une troisième direction, chacune des trois directions étant perpendiculaire à chaque autre, dans lequel le substrat (4) est mobile par le support de substrat dans la première direction (A) ;
- un support de cible avec une cible (3), agencé à l'intérieur de la chambre à vide et dans lequel la cible (3) s'étend sensiblement sur la totalité de la longueur dans la deuxième direction (B) du substrat (4) et parallèlement au substrat (4) ;
- au moins un laser (2) pour irradier la cible (3), créant de ce fait un plasma (5) de matière qui se dépose sur le substrat (4), dans lequel la position d'incidence (7) du laser (2) sur la cible (3) est mobile parallèlement à la deuxième direction (B) du substrat (4) ; et
- une unité de commande pour commander le mouvement du support de substrat et le mouvement de la position d'incidence (7) du laser (2) sur la cible (3)
dans lequel l'unité de commande réinitialise la position d'incidence (7) du laser (2), quand on regarde dans la direction de mouvement (B), au bord le plus proche du substrat (4) lors de l'arrivée au niveau du bord distal du substrat (4), **caractérisé par**
- un moyen de blocage pour bloquer le dépôt du nuage de plasma (5) sur le substrat (4) pendant la réinitialisation de la position d'incidence (7) du laser (2) sur la cible (3).

2. Dispositif (1) selon la revendication 1, dans lequel le mouvement de la position d'incidence (7) du laser (2) est linéairement lié au mouvement du support de substrat (4).

3. Dispositif (1) selon l'une quelconque des revendications, dans lequel la position d'incidence (7) du laser sur la cible (3) est également mobile dans la première direction (A) le long de la surface de la cible (3).

4. Dispositif (1) selon la revendication 3, dans lequel la cible (3) est au moins partiellement incurvée, de préférence cylindrique, sur la totalité de la longueur dans la deuxième direction (B) du substrat (4).

5. Dispositif (1) selon la revendication 4, dans lequel la cible (3) est une tige cylindrique.

6. Dispositif (1) selon la revendication 5, dans lequel la cible (3) est rotative autour de son axe parallèle à la deuxième direction (B) du substrat (4).

7. Dispositif (1) selon l'une quelconque des revendications précédentes, dans lequel la longueur dans la deuxième direction (B) du substrat (4) est d'au moins 20 centimètres.

8. Dispositif (1) selon l'une quelconque des revendications précédentes, dans lequel le substrat (4) comprend une couche de verre munie d'une couche de matière électroluminescente.

9. Procédé pour déposer une matière par dépôt par laser pulsé avec un dispositif (1) selon l'une quelconque des revendications précédentes, le procédé comprenant les étapes répétitives de :
- déplacement du substrat (4) dans la première direction (A) à une vitesse constante ;
- déplacement de la position d'incidence (7) du laser (2) sur la cible (3) dans la deuxième direction (A) à une vitesse constante, quand on regarde dans la deuxième direction (B), depuis le bord le plus proche du substrat (4) vers le bord distal du substrat (4) ;
**caractérisé par**
- le déplacement de la position d'incidence (7) du laser (2) en arrière, quand on regarde dans la deuxième direction (B), depuis le bord distal du substrat (4) jusqu'au bord le plus proche du substrat (4), inhibant le dépôt de particules sur le substrat (4).
